# EUROPEAN PATENT APPLICATION

(11) **EP 4 617 976 A1**
(43) Date of publication of application: **17.09.2025**
(21) Application number: 24163962.4
(22) Date of filing: 15.03.2024
(51) Int. Cl.: G06Q 10/10, G06F 3/01, G06N 3/006, G06Q 50/00

(54) **SYSTEM AND METHOD TO EXECUTE USER INTENT BY OPTIMIZING INTERACTION STEPS USING OBJECTIVE JOURNEY MAPPING IN A COMPUTER SIMULATED ENVIRONMENT**

(71) Applicant: Siemens Aktiengesellschaft, 80333 München (DE)
(72) Inventor: MANICKAM, Ramesh, 560100 Bangalore, Karnataka (IN)
(74) Representative: HKW Intellectual Property PartG mbB

(57) **Abstract**

Presented is a system (100) and a method (300) to optimize one or more actions to be performed by a user in a computer simulated environment (108), the method comprising receiving an input comprising an intent to execute the one or more action by the user. The method (300) further comprising analyzing if an optimized one or more actions exist in a database comprising one or more optimized actions relating to the intent. The method (300) further comprising generating a plurality of options relating to one or more actions for the user based on past data and present data and simulating each option of the options relating to one or more actions. The method (300) resulting in a determination of an optimal action to execute the one or more actions defined in the intent input of the user based on the simulated options.

## Description

The present invention relates generally to the field of computer simulation environment, and specifically to methods and systems for executing user intent by optimizing interaction steps based on user input by objective journey mapping in an industrial metaverse, thereby increasing sustainability.

A network of interconnected virtual worlds designed for collaborative interactions between users and machines serves as a digital ecosystem to engage and collaborate seamlessly. In the realm of computer-simulated environments, executing user intent through a system involves a series of meticulously crafted interactions. Each interaction necessitates the active involvement of a user in the loop, who is tasked with making decisions to progress to the subsequent interaction. Unfortunately, the inherent nature of these interaction steps contributes to a notable increase in energy consumption and a corresponding rise in the carbon footprint associated with the entire simulated execution process.

Within the expansive landscape of computer simulated environments like an industrial metaverse, characterized by a persistent operational model and the simultaneous engagement of multiple users, each harboring unique intents, the cumulative environmental impact is particularly pronounced. Recognizing this challenge, the present invention aims to revolutionize the execution of user intent within computer-simulated environments by intelligently optimizing interaction steps. Through the strategic guidance of users along a purposeful journey facilitated by intelligent algorithms, there is a need to substantially reduce the carbon footprint and energy consumption associated with each interaction.

Additionally, autonomous systems, characterized by minimal user intervention, often require user involvement to address new challenges, leading to increased energy consumption and reduced sustainability. When faced with problems beyond their current capabilities, autonomous systems seek user support to understand and solve the issue. Traditional approaches either rely on extensive data for autonomous training or necessitate user presence for problem-solving, both of which contribute to high energy consumption and reduced sustainability.

Therefore, the object of the present invention is achieved by a method for executing user intent by optimizing interaction steps based on user input by objective journey mapping in a computer simulated environment, as disclosed herein.

The method comprises of receiving an input comprising an intent to execute the one or more action by the user. The method further comprises of analyzing if an optimized one or more actions exist in a database comprising one or more optimized actions relating to the intent. Furthermore, the method comprises of generating a plurality of options relating to one or more actions for the user based on past data and present data, and simulating each option of the options relating to one or more actions. The method further comprises of determining an optimal action to execute the one or more actions defined in the intent input of the user based on the simulated options. Advantageously, this optimized approach optimizes system capabilities while reducing energy consumption, and enhancing sustainability in autonomous systems.

The step of optimizing interaction steps further comprises of generating a probability against each option of the one or more action options, the probability based on a least number of actions required after each option to complete the action. Probability analysis offers an objective and quantitative approach to evaluating different paths or actions. Instead of relying on intuition or subjective judgment, users can base their decisions on probabilistic assessments, reducing bias and increasing the reliability of decision-making.

The step of optimal action further comprises the generation of the optimal action based on the probability and an information relating to a previous success rate for each action to complete the action, the information being stored in a storage unit. Therefore, the users can dynamically adjust their approach based on real-time feedback and changing circumstances, leveraging both probabilistic assessments and past experiences to optimize decision-making and task execution.

The step of optimal action further comprises the options relating to one or more actions for the user is generated based on a user request. When training the system to solve the problem, the user seeks the system to generate alternative options to solve the problem and finally validating it with the user in the loop, thereby, optimizing the user interaction as a basis for the solution.

The step of optimal action further comprises displaying the plurality of options along with the respective probabilities and the previous success rate at each action of the one or more actions. The display of the probability facilitates comparative analysis between different options.

The step of optimizing interactions further comprises executing the solution based on the user selection from the displayed options or based on the determination that no optimization is required. The method further comprises the user being at a remote location operating the computer simulated environment. Therefore, remote work and remote operation are the key advantage of the present invention, by real time interacting in the computer simulated environments like virtual or mixed reality environment.

Throughout the present disclosure, the term "industrial environment" may refer to plurality of industrial assets connected with each other to achieve a function. The industrial environment may be comprised of industrial assets such as industrial machines, industrial devices, industrial controllers, and so forth.

Throughout the present disclosure, the term "computed simulated environment" as used herein refers to three-dimensional (3D) representation of a real or physical world. It can be understood as a virtual world. The computer-simulated environment is accessible by a user, i.e., it is accessible from the real/physical world. This comprises data exchange between the computer-simulated environment and the real/physical world. In particular, the computer-simulated environment can be understood as the "metaverse" and "industrial metaverse", "digital twin" or "computer simulated environment" may be interchangeably used in the present invention. It is also possible to interact with the computer-simulated environment, i.e., to influence or use processes, components and/or functions in the computer-simulated environment. Therefore, processes in the computer-simulated environment may have direct influence on processes in the real/physical world, e.g., by modelling control processes virtually.

Throughout the present invention, it is to be understood that the terms "one or more actions" and "interaction" or "interaction steps" are utilized interchangeably to depict a series of actions that are taken to complete an intent. For example: when someone knocks at the door, the intention is to know who is knocking. To complete the intention the user or an avatar in a computer simulated environment needs to get up from his chair, walk, see the eye lid in the door or enquire about the person on the door.

For example, it is possible that a user can access the computer-simulated environment via a user device, e.g., a virtual reality (VR) or augmented reality (AR) device. The counterpart of the computer-simulated environment does not necessarily have to exist but can be for example a 3D model. It is also possible that physical forces and phenomena, e.g., gravity, are represented in a different way in the computer-simulated environment than in the real world, e.g., gravitational acceleration. For the purpose of this invention, the metaverse is comprised of a plurality of digital twins corresponding to real-world one or more assets in the industrial environment.

The object of the invention is also achieved by a computer program product comprising machine readable instructions, that when executed by one or more processing units, cause the one or more processing units to perform the aforementioned method steps. The computer program product further comprises a storage unit communicatively coupled to the one or more processing units. The storage unit comprises a module stored in the form of machine-readable instructions executable by the one or more processing units. The module is configured to perform method steps as described above. The execution of the module may also be performed using co-processors such as Graphical Processing Unit (GPU), Field Programmable Gate Array (FPGA) or Neural Processing/Compute Engines.

The object of the present invention is further achieved by a computer readable medium on which program code sections of a computer program are saved, the program code sections being loadable into and/or executable in a system to make the system execute the method steps described above when the program code sections are executed in the system. This summary is provided to introduce a selection of concepts in a simplified form that are further described below in the following description. It is not intended to identify features or essential features of the claimed subject matter. Furthermore, the claimed subject matter is not limited to implementations that solve any or all disadvantages noted in any part of this invention.

The realization of the invention by a computer program product and/or a non-transitory computer-readable storage medium has the advantage that computer systems can be easily adopted by installing computer program in order to work as proposed by the present invention.

The computer program product can be, for example, a computer program or comprise another element apart from the computer program. This other element can be hardware, for example a memory device, on which the computer program is stored, a hardware key for using the computer program and the like, and/or software, for example a documentation or a software key for using the computer program.

The above-mentioned attributes, features, and advantages of the present invention and the manner of achieving them, will become more apparent and understandable (clear) with the following description of embodiments of the invention in conjunction with the corresponding drawings. The illustrated embodiments are intended to illustrate, but not limit the invention.

The present invention is further described hereinafter with reference to illustrated embodiments shown in the accompanying drawings, in which:
FIG 1 is a block diagram representation of a system for executing user intent by optimizing interaction steps using objective journey mapping, in accordance with one or more embodiments of the present invention;
FIG 2 is a block diagram representation of the apparatus for executing user intent by optimizing interaction steps using objective journey mapping, in accordance with one or more embodiments of the present invention;
FIG 3 is a flowchart of a method to execute user intent by optimizing interaction steps using objective journey mapping, in accordance with one or more embodiments of the present invention;
FIG 4 is a depiction of an objective journey map against a sequential journey map, in accordance with one or more embodiments of the present invention; and
FIG 5A and FIG 5B are a depiction of an exemplary embodiment of optimizing a process with user intervention, in accordance with one or more embodiments of the present invention.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

The present invention discloses a novel approach to optimize interaction steps by incorporating intelligent guidance mechanisms. The present invention addresses this challenge by introducing a solution that optimizes both system capabilities and user involvement. By leveraging system intelligence, the invention facilitates a balanced approach that minimizes energy consumption while ensuring effective problem - solving.

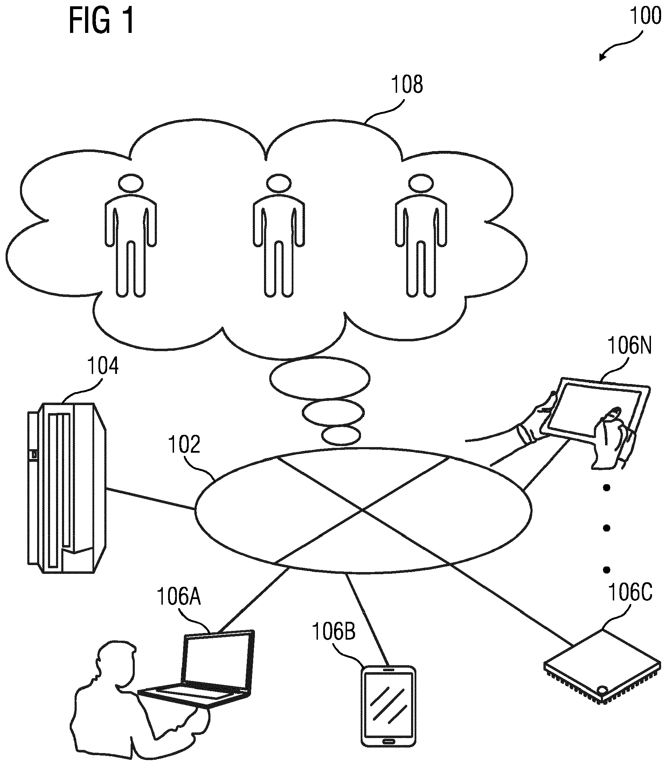

Referring to Fig. 1, illustrated is a system 100 for executing user intent by optimizing interaction steps using objective journey mapping, in accordance with one or more embodiments of the present invention. It may be appreciated that the system 100 described herein may be implemented in various forms of hardware, software, firmware, special purpose processors, or a combination thereof. One or more of the present embodiments may take a form of a computer program product comprising program modules accessible from computer-usable or computer-readable medium storing program code for use by or in connection with one or more computers, processors, or instruction execution system. For the purpose of this description, a computer-usable or computer-readable medium may be any apparatus that may contain, store, communicate, propagate, or transport the program for use by or in connection with the instruction execution system, apparatus, or device. The medium may be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and digital versatile disc (DVD). Both processors and program code for implementing each aspect of the technology may be centralized or distributed (or a combination thereof) as known to those skilled in the art.

FIG 1 is a block diagram of a system 100 for executing user intent by optimizing interaction steps using objective journey mapping in an industrial metaverse scenario, according to an embodiment of the present invention. The system 100 comprises a computer simulated environment 108, one or more user terminals 106A to 106N, and an apparatus 104 communicating over a network 102. The user terminal 106 includes a first user terminal 106A of a first user, a second user terminal 106B of a second user, a third user terminal 106C of a third user and so on. The term 'user' may be interchangeably construed as denoting the avatar within the computer-simulated environment 108. The computer simulated environment 108 is virtual representation of a real or physical world. It can be understood as a virtual world representing one or more elements/entities of the real-world such as assets, machines, robots, operators, workers, operators, objects, etc. The computer-simulated environment 108 is accessible by a user, i.e., it is accessible from the real/physical world. In particular, the computer-simulated environment 108 can be understood as a metaverse environment, a digital twin, a digital thread, autonomous systems, knowledge graphs, or a combination thereof. It is also possible to interact with the computer-simulated environment 108, i.e., to influence or use processes, components and/or functions in the computer-simulated environment 108. The user or the avatar may interact with the objects rendered in the metaverse.

For example, it is possible that a user can access the computer-simulated environment 102 via an interface, e.g., a virtual reality (VR) or augmented reality (AR) interface. For the purpose of this invention, the metaverse is comprised of one or more animated scenes being rendered corresponding to the plurality of entities interacting in the industrial environment. The metaverse may comprise a plurality of computer-simulated components. The computer simulated components can for example be understood as a representation, in particular a 3D or virtual representation, of a real or physical component. A component can for example be a room, a building, an item, or an object. The computer-simulated component can have different functionalities/features, e.g., an access interface. The metaverse can be realized by a hosting environment. The hosting environment can be for example be implemented as a cloud environment, an edge-cloud environment and/or on specific devices, e.g., mobile devices.

Throughout the present disclosure, the terms similar to "user terminal" 106 A and "one or more user terminals" 106A, 106B, ... 106N refers to any electronic device configured for capturing, acquiring, and transmitting data from a user to the apparatus. The user terminal may take various forms depending on the specific application of the system 100. In an example, the user terminal 106A includes one or more of a keyboard, a mouse, a touchscreen display, a microphone, a camera, or any other hardware component that enables the user to interact with the system 100. In another example, the user terminal 106A may comprise of multiple modes of acquisition of the data in addition to a user input and therefore the user terminals 106A, 106B, ... 106N may comprises of a combination of voice assistants, specialized input devices, data entry devices, touch screen interfaces, camera modules, digital cameras, surveillance cameras, aerial imaging devices, 3D imaging devices, wearable devices and the like. For the simplicity of this invention, we may refer to a single user terminal 106.

In one embodiment, the apparatus 104 is deployed in a cloud computing environment. As used herein, "cloud computing environment" refers to a processing environment comprising configurable computing physical and logical resources, for example, networks, servers, storage, applications, services, etc., and data distributed over the network 102, for example, the internet. The cloud computing environment provides on-demand network access to a shared pool of the configurable computing physical and logical resources. The network 102 is referred as a distributed network or communication network throughout the invention. The apparatus 104 may include a module for managing access control for a plurality of metaverses or digital twins interacting in a computer simulated collaborative environment over a distributed network.

Additionally, the system 100 comprises a cloud computing device configured for providing cloud services for managing access control for a plurality of user terminals 106A to 106N interacting in a computer simulated collaborative environment over a distributed network. The cloud computing device comprises a cloud communication interface, a cloud computing hardware and OS, and a cloud computing platform. The cloud computing hardware and OS may include one or more servers on which an operating system (OS) is installed and includes one or more processing units, one or more storage devices for storing data, and other peripherals required for providing cloud computing functionality. The cloud computing platform is a platform which implements functionalities such as data storage, data analysis, data visualization, data communication on the cloud hardware and OS via APIs and algorithms; and delivers the aforementioned cloud services using cloud-based applications.

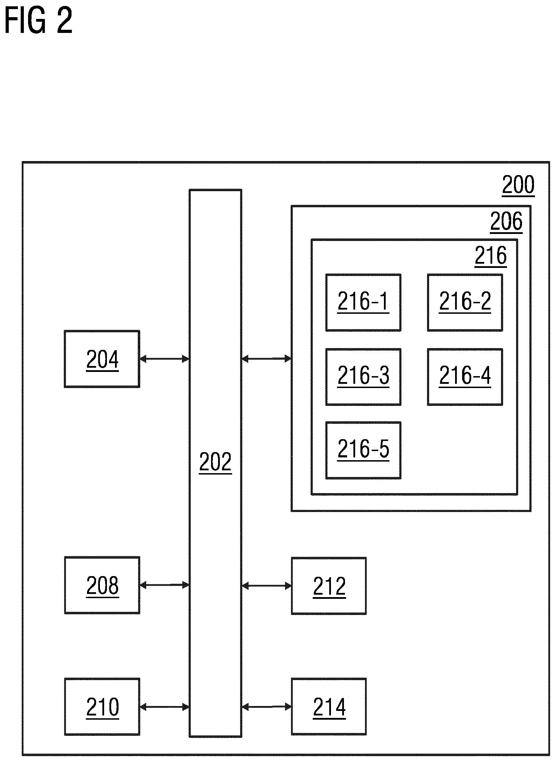

FIG 2 is a block diagram of an exemplary apparatus 200 for efficiently rendering one or more scenes in a computer simulated environment, according to an embodiment of the present invention. In an exemplary embodiment, the exemplary apparatus 200 is communicatively coupled, using a distributed network 102, to one or more user terminals 106A to 106N, and the computer simulated environment 108 to render the computer simulated environment 102.

The apparatus 200 may be a personal computer, a laptop computer, a tablet, a server, a virtual machine, and the like. The apparatus 200 includes a bus 202, a processing unit 204, a memory 206 comprising a module 216, a storage unit 208, a database 210, an input unit 212, and an output unit 214.

The processing unit 204 as used herein, means any type of computational circuit, such as, but not limited to, a microprocessor, microcontroller, complex instruction set computing microprocessor, reduced instruction set computing microprocessor, very long instruction word microprocessor, explicitly parallel instruction computing microprocessor, graphics processor, digital signal processor, or any other type of processing circuit. The processing unit 204 may also include embedded controllers, such as generic or programmable logic devices or arrays, application specific integrated circuits, single-chip computers, and the like. In the context of the present invention, the processing unit 204 may be interchangeably referred to as a "processor."

The storage unit 208 comprises the database 210 for storing intent history, interactions/actions options, information relating to the success of each interaction and user profiles (also referred to avatar). The user profiles would contain structured data fields such as user IDs, preferences, demographic information, and past interaction history. Intent history records would include data fields capturing details like intent IDs, associated actions, success rates, and timestamps. Additionally, the storage unit 208 may store additional unstructured data, such as multimedia files, documents, logs, or backups related to the optimization process. The storage unit 208 and/or database 210 may be provided using various types of storage technologies, such as solid-state drives, hard disk drives, flash memory, and may be stored in various formats, such as relational databases, non-relational databases, flat files, spreadsheets, and extended markup files, etc.

The memory 206 may be non-transitory volatile memory and/or non-volatile memory. The memory 206 may be coupled for communication with the processing unit 204, such as being a computer-readable storage medium. The processing unit 204 may execute instructions and/or code stored in the memory 206. A variety of computer-readable instructions may be stored in and accessed from the memory 206. The memory 206 may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like.

In the present embodiment, the memory 206 includes the module 216 stored in the form of machine-readable instructions on any of the above-mentioned storage media and may be in communication to and executed by the processing unit 204. When the machine-readable instructions are executed by the processing unit 204, the module 216 causes the processing unit 204 to efficiently render one or more scenes in a computer simulated environment.

The module 216 comprises of an intent analyzation module 216-1, an option generation module 216-2, a simulation module 216-3, a probability generation module 216-4, and an optimal action generation module 216-5.

The intent analyzation module 216-1 is configured for acquiring input data relating to an industrial environment from various sources within the metaverse. The input data may include text chat logs, voice conversations, avatar movements, interactions with virtual objects, or a combination thereof. The acquired data undergoes processing to extract relevant information and to understand various inputs using relevant algorithms. With the processed data, the system identifies patterns and context to discern the user's intent by comparing the user's actions and statements against a database of known intents or using machine learning algorithms to recognize new patterns and intents. The intent analyzation module 216-1 may further include contextual understanding critical for accurate intent analysis. The intent analyzation module 216-1 takes into account factors such as the user's location within the metaverse, their previous interactions, ongoing events, and the virtual environment itself to better interpret the user's intentions. Additionally, the intent analyzing module is further configured to learn and adapt to a users' behavior over an extended amount of time.

The option generation module 216-2 is configured to generate multiple options for one or more actions based on the identified intent. The option generation module 216-2 is configured to pre-process the intent analyzed to determine that the solution is correctly analyzed and if there is a requirement of a user input to assist in the action to be performed. Based on the past information comprising sensor readings, maintenance records, operational data, and design iterations, forms a crucial part of the digital twin or digital thread. This historical data provides valuable insights into the behavior, performance, and evolution of the physical asset or product over time that helps to determine multiple methods of achieving the solution to execute an action based on the analyzed intent. In addition to the past information, the option generation module 216-2 is further configured to consider the present data comprising digital shadowing data and real-time information or data that is relevant to the current state of the virtual environment or the ongoing interactions. Additionally, the present data may also include avatar position, orientations, and movements of avatars in the virtual world. Based on the past and present data, one or more actions or interactions may be generated to be presented to the avatar for the user input. The generated multiple options for one or more actions based on the identified intent may be presented to the user as a recommendation result.

The simulation module 216-3 is configured to simulate the one or more actions or interactions to verify the implementation of the solution in the virtual world based on the recommendation provided in the form of one or more actions options to the user. The simulation unit is further configured to enable virtual entities, such as avatars, NPCs (non-player characters), or autonomous agents, to interact with each other and with the virtual environment. Furthermore, the simulation module 216-3 enables realistic object manipulation behaviours, including physicsbased interactions and animations. The recommendation result generated by on the option generation module 216-2 are simulated to derive a probability relating to the success of the each of the one or more actions that may result in a successful completion of the intent.

The probability generation module 216-4 is configured to generate a probability against each option of the one or more action options. The probability is generated based on a least number of actions required after execution of each option of the one or more actions/interactions to complete the intent analyzed earlier. The probability generation module 216-4 may also consider factors such as the current state of the virtual environment, the capabilities and constraints of the user or virtual entity, historical data or experience, any contextual information available, or a combination thereof for the calculation of the probability.

The optimal action generation module 216-5 is configured to generate an optimal action based on the probability generated by the probability generation module 216-4 and based on the past data regarding the success of each option of the one or more actions generated by the option generation module 216-2.

The processing unit 204 is configured for performing all the functionality of the module 216. The processing unit 204 is configured to receive data from the computer simulated environment comprising of one or more avatars, each avatar being controlled by one or more user terminals. The processing unit 204 is further configured to identify a real-world scene from the industrial environment in real-time. Herein, the real-world scene is identified using one or more machine learning models on the received visual data. The processing unit 204 is further configured to fetch and analyze the data stored in the intent optimization database to extract insights, patterns, and trends related to user intents, preferences, and behaviors. The analysis may involve applying various algorithms and techniques to interpret the structured data stored in the database effectively. The processing unit 204 is configured to execute intent optimization algorithms designed to recommend optimal actions or strategies for fulfilling user intents. Based on the results of data analysis and algorithm execution, the processing unit makes decisions regarding which actions to recommend or prioritize for users. These decisions aim to maximize the likelihood of successfully fulfilling user intents while considering factors such as efficiency, effectiveness, and user satisfaction. The processing unit 204 is further configured to render the real-time processing and incorporates feedback from users, system performance metrics, and external sources to continuously refine and improve intent optimization strategies over time. The real-time processing capability ensures a seamless and responsive user experience within the intent optimization system and feedback-driven approach allows the system to adapt to changing user needs and preferences dynamically.

The input unit 212 may provide ports to receive input from input devices such as monitor, keypad, touch-sensitive display, camera (such as a camera receiving gesture-based inputs), head mounted devices, etc. capable of receiving a primary input based on user's expressed or inferred intent, which may be provided through direct input (e.g., text input, voice commands) or inferred from user behavior and context. Additionally, the input unit is configured to acquire information about the user, including preferences, past interactions, demographic data, and other relevant attributes, helps personalize the options provided by the system. The display unit 214 may provide ports to output data via output device with a graphical user interface for displaying one or more options for actions in the computer simulated virtual environment. The bus 202 acts as interconnect between the processing unit 204, the storage unit 208, the memory 206, the input unit 212, and the display unit 214.

Those of ordinary skilled in the art will appreciate that the hardware depicted in FIG 2 may vary for implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter also may be used in addition to or in place of the hardware depicted. The depicted example is provided for the purpose of explanation only and is not meant to imply architectural limitations with respect to the present disclosure.

The present invention is not limited to a particular computer system platform, processing unit, operating system, or network. One or more aspects of the present invention is distributed among one or more computer systems, for example, servers configured to provide one or more services to one or more client computers, or to perform a complete task in a distributed system. For example, one or more aspects of the present invention is performed on a client-server system that includes components distributed among one or more server systems that perform multiple functions according to various embodiments. These components comprise, for example, executable, intermediate, or interpreted code, which communicate over a network using a communication protocol. The present invention is not limited to be executable on any particular system or group of system, and is not limited to any particular distributed architecture, network, or communication protocol.

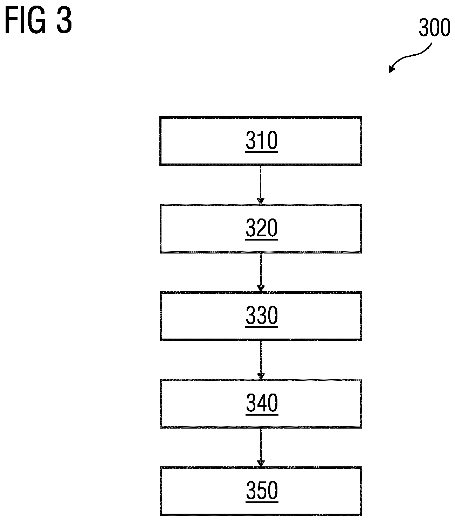

Referring to FIGS 2 and 3 in combination, the various steps of the method 300 as described hereinafter may be executed in the apparatus 200, or specifically in the processor 204 of the apparatus 200, for optimizing interaction steps through user in the loop by objective journey mapping, in an industrial metaverse increasing sustainability. For purposes of the present disclosure, optimizing the one or more interactions

In one or more embodiments of the present invention, at step 301, the method 300 includes receiving an input comprising an intent to execute the one or more action by the user. The input may be generated by the same user or a different user. As used herein, the term "intent" comprises of at least one of an aim, an objective, a purpose, or a goal to do a specific task. The user may be an avatar in the computer simulated environment. To receive an intent, data is gathered and processed to identify patterns and context to discern the user's intent. This involves comparing the user's actions and statements against a database of known intents or using machine learning algorithms to recognize new patterns and intents.

In one or more embodiments of the present invention, at step 302, the method 300 further comprises of analysing the intent to determine if an optimized one or more actions exist in a database comprising one or more optimized actions relating to the intent. The database comprises of a plurality of information.

In one or more embodiments of the present invention, at step 303 of the method 300, the method comprises of generating a variety of options related to one or more actions for the user. These options are derived from a combination of past data and present data, which may include historical user interactions, environmental conditions, system states, or other relevant factors. By leveraging this data, the system generates a range of potential actions or choices available to the user in the current context.

In one or more embodiments of the present invention, at step 303 of the method 300, the method comprises of simulating each of these options to assess their potential outcomes and consequences. Through simulation, the system can predict the effects of different actions on the overall task or objective. This allows for informed decision-making by providing insights into the likely outcomes of each option before the user commits to a specific course of action. Therefore, the system to offer users a diverse set of options for action based on past and present data, while also allowing for the evaluation of potential outcomes through simulation. By considering both historical data and real-time information, the system enhances decision-making capabilities and supports more effective user interactions within the given environment.

In one or more embodiments of the present invention, at step 304 of the method 300, the method involves generating a probability associated with each option among the available action choices. This probability is determined based on the expected minimum number of actions needed to complete the task after selecting each respective option from the set of possible actions. Essentially, the system evaluates the likelihood of success for each action by considering the number of subsequent actions required to achieve the desired outcome. Options with fewer subsequent actions needed to complete the task are assigned higher probabilities, reflecting their greater likelihood of leading to successful task completion within the given context. This approach helps prioritize actions that are more efficient and likely to result in desired outcomes, contributing to improved decision-making and task execution efficiency. The probability may also be based on other factors then the number of interactions required to complete an action.

In one or more embodiments of the present invention, at step 305 of the method 300, the method comprises of determining an optimal action to execute the one or more actions defined in the intent input of the user based on the simulated options. Additionally, the generation of the optimal action is based on the generated probability and an information relating to a previous success rate for each action to complete the action, the information being stored in a storage unit.

Therefore, the proposed solution provides improved mechanism of optimization of interaction steps in industrial metaverse environments, thereby reducing energy consumption and carbon footprint. In the existing solution, heavy processing and huge amount of storage of data that results in extensive energy consumption. The options provided to the user/avatar based on the determination of least number of steps required to complete a specific task or complete one or more action aids in the reduced energy consumption and carbon footprint, increased sustainability, enhanced efficiency and resource optimization, improved user experience, and adaptability to changing conditions. The method provided in the proposed disclosure reduces the energy consumption in a big way and the manual mistakes happening during training are drastically minimized. As a result, the proposed solution is simple and can be easily, effectively implemented with enhanced efficiency.

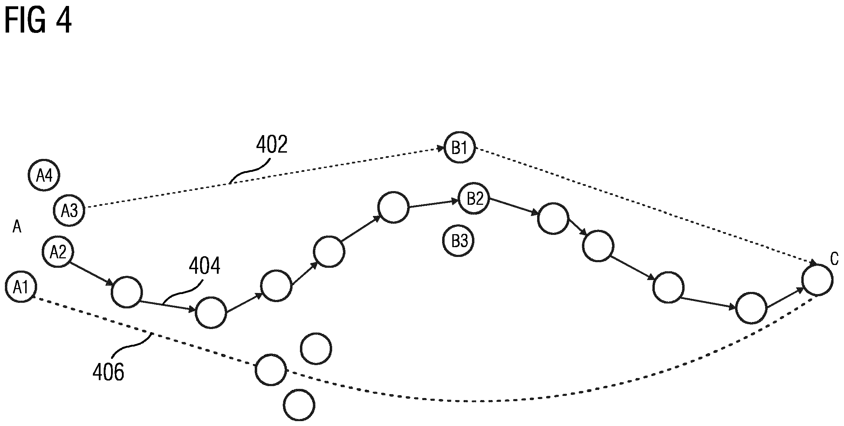

Illustrated in FIG 4 is a comparison between an objective journey map and a sequential journey map, as outlined in one or more embodiments of the present invention. The journey map 400 delineates the sequence of interactions occurring in a chronological order of actions, exchanges, or engagements between the user and the computer simulated environment. Within the metaverse or virtual environment context, this sequence outlines the steps a user takes while navigating, exploring, and interacting within the digital space.

A sequential journey 404, marked from start point A2 through midpoints like B2, ultimately arrives at end point C. In contrast to the linear progression of the sequential journey map, objective journey maps represent multiple potential paths to the same endpoint. For example, objective journey maps 402 and 406 show alternative routes from different starting points (A1 and A3) to the common endpoint, point C. Each objective journey involves reaching the endpoint using only one additional interaction beyond the initial one, showcasing different user paths and decision points.

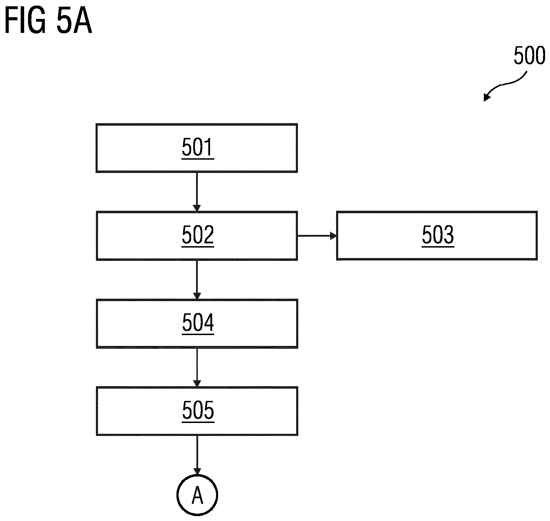

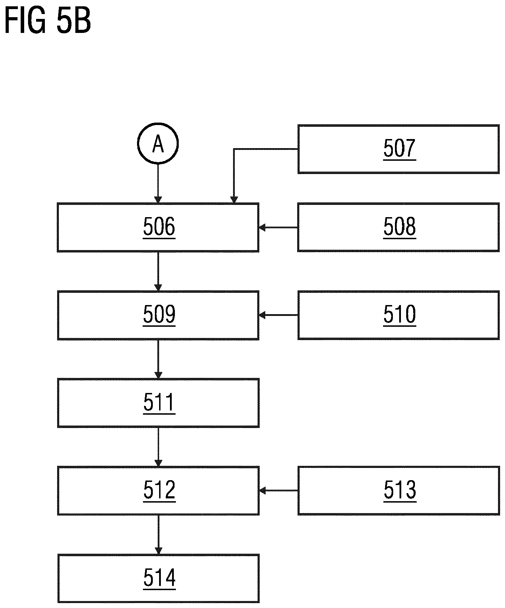

Referring to FIG 5A and FIG 5B, illustrates an exemplary embodiment of optimizing process based on a user intervention, in accordance with one or more embodiments of the present invention. In a computer simulated environment, to execute a user intention, the system generates a set of interactions in step 501. These set of interactions based on the environment conditions and the intelligence of the system. In Step 502, it is determined if the system understands the intent and based on the goal, if there is a requirement of optimization or not. In a case there is no optimization required, the system executes a sequential journey. In step 503, where there is a requirement of optimization, the processor is configured to request of user input. For example, in case of a digital twin of the autonomous system, it notifies the user about anomaly encountered during execution of a process. The user analyses the problem in hand remotely in step 504 and to meet the intent, goes through a set of interactions remotely and teaches the system to solve the problem.

In step 505, when training the system to solve the problem, the user seeks the system to generate alternative options to solve the problem. In step 506, the system generates possible interaction options in the virtual world based on the connected information of the digital threads 507 and present data relating to sensor information based on the digital shadowing 508. The system provides interaction options to the user to verify and implement the solution based on the digital simulations of future data 510. Finally, the validation happens with the user in the loop optimizing the user interaction on the basis of the solution. When the user teaches the system by remote operation, the teaching consists of a set of interactions, which are broken down in to sub interactions to meet the desired intent. In step 514, in industrial metaverse scenario in the virtual world, the user is provided with information that he normally cannot see in the physical world, for example, but not limited to contextual data, historical data, system state or a combination thereof. Contextual data refers to data about the current context, such as environmental conditions, device capabilities, location, time of day, and user activity, influences the available action options.

The historical data is insights from past user interactions, intent history, and behaviour patterns inform the system's decision-making process and help tailor recommendations to the user's preferences and past experiences. The system state is information about the current state of the system, including available resources, system capabilities, and external dependencies, affects the feasibility and suitability of different action options. Additionally, the user is presented with the data like past success rate of a particular interaction as well, which is stored in the form of past data in the database. With the provided by the processor to the user, the user is able to take intelligent decisions along with the intelligent systems recommendations provided from past and present connected data to solve the problem much more efficiently through intelligent interactions.

As a result, in the computer simulated environment, the user does not go through a sequential journey to solve the real-life problems in the virtual world. Based on the options provided by the system along with the probability and the past success rate of each of the one or more action, the user undertakes an objective journey. The interaction or action options changes in real time to recommend the user to meet his intent with high level probability of success.

The present invention discloses a system and method for optimizing interactions through user in the loop by objective journey mapping, in an Industrial metaverse scenario. The present invention relates to a system and method for optimizing interaction steps within industrial metaverse environments to reduce energy consumption, minimize carbon footprint, and increase sustainability. In industrial metaverse scenarios characterized by continuous activity and multiple users, each interaction step contributes to energy consumption and carbon emissions. The invention addresses this challenge by intelligently guiding users through an objective journey, thereby optimizing interaction steps and reducing environmental impact. By streamlining processes, enhancing efficiency, and promoting sustainable practices, the invention improves user experience and supports long-term viability within industrial metaverse ecosystems.

The invention pertains to a system and method designed to optimize interaction steps in industrial metaverse environments, thereby reducing energy consumption and carbon footprint while increasing sustainability. In such environments, characterized by continuous activity and numerous users, each interaction step contributes to environmental impact. To address this challenge, the present invention introduces an intelligent guidance mechanism that guides users through an objective journey, optimizing interaction steps and minimizing unnecessary energy consumption. By streamlining processes and enhancing efficiency, the invention maximizes resource utilization and supports sustainable practices within industrial metaverse environments. Additionally, the system's adaptability allows it to adjust to changing circumstances and user needs, ensuring continuous optimization of interaction steps over time. Overall, the invention offers a novel solution to minimize energy consumption, reduce carbon footprint, and increase sustainability within industrial metaverse environments. By optimizing interaction steps and promoting efficient resource utilization, the invention contributes to improved environmental practices and enhances the overall user experience within digital ecosystems.

While the present invention has been described in detail with reference to certain embodiments, it should be appreciated that the present invention is not limited to those embodiments. In view of the present invention, many modifications and variations would be present themselves, to those skilled in the art without departing from the scope of the various embodiments of the present invention, as described herein. The scope of the present invention is, therefore, indicated by the following claims rather than by the foregoing description. All changes, modifications, and variations coming within the meaning and range of equivalency of the claims are to be considered within their scope.

### List of references

- 100: a system
- 102: a network
- 104: an apparatus
- 106A-106N: user terminals
- 108: a computer simulated environment
- 200: an apparatus
- 202: a bus
- 204: a processing unit
- 206: a storage unit
- 210: a database
- 212: an input unit
- 214: an output unit
- 216: modules
- 216-1: an intent analyzation module
- 216-2: an option generation module
- 216-3: a simulation module
- 216-4: a probability generation module
- 216-5: an optimal action generation module
- 300: a flowchart of a method to execute user intent by optimizing interaction steps using objective journey mapping
- 400: an objective journey map against a sequential journey map
- 500: an exemplary embodiment of optimizing a process with user intervention

## Claims

1. A method (300) to optimize one or more actions to be performed by a user in a computer simulated environment, the method (300) comprising:
receiving, by a processor (204), an input comprising an intent to execute the one or more action by the user;
analyzing, by the processor (204), if an optimized one or more actions exist in a database comprising one or more optimized actions relating to the intent;
generating, by the processor (204), a plurality of options relating to one or more actions for the user based on past data and present data;
simulating, by the processor (204), each option of the options relating to one or more actions; and
determining, by the processor (204), an optimal action to execute the one or more actions defined in the intent input of the user based on the simulated options.

2. The method (300) according to claim 1, the method (300) further comprising:
generating, by the processor (204), a probability against each option of the one or more action options, the probability based on least number of actions required after each option to complete the action.

3. The method (300) according to claims 1 and 2, wherein the generation of the optimal action is based on the probability and an information relating to a previous success rate for each action to complete the action, the information being stored in a storage unit.

4. The method (300) according to claims 1 to 3, wherein the options relating to one or more actions for the user is generated based on a user request.

5. The method (300) according to claims 1 to 4, wherein
the intent comprises of at least one of an aim, an objective, a purpose, or a goal to do a specific task;
the past data comprises of historical data; and
the present data comprises of sensor data and contextual data.

6. The method (300) according to claims 1 to 5, the method (300) further comprising:
displaying, by the processor (204), the plurality of options along with the respective probabilities and the previous success rate at each action of the one or more actions;

7. The method (300) according to claims 1 to 6, the method (300) further comprising:
executing, by the processor (204), the solution based on the user selection from the displayed options; and
executing, by the processor, the solution based on the determination that no optimization is required.

8. The method (300) according to claims 1 to 7, wherein the user is at a remote location operating the computer simulated environment.

9. The method (300) according to claims 1 to 8, the method further comprising:
storing, in the database, each action of the one or more actions for each executed intent.

10. An apparatus (200) for defining a semantic framework for a plurality of elements in a computer simulated environment, the apparatus comprising:
one or more processing units (204); and
a memory (206) communicatively coupled to the one or more processing units (204), the memory (206) comprising a module (216) stored in the form of machine-readable instructions executable by the one or more processing units (204), wherein the module is configured to perform the method (300) steps according to claims 1 to 9.

11. A system (100) for efficiently rendering of one or more scenes in a computer simulated environment (108), the system comprising:
a plurality of user terminal devices (106A to 106N),
a distributed network (102) communicatively coupled to the computer simulated collaborative environment (108); and
an apparatus (104) according to claim 10, communicatively coupled to the distributed network (102) and the computer simulated environment (108), wherein the apparatus (104) is for defining a semantic framework for a plurality of elements in a computer simulated environment (108), according to any of the method claims 1 to 9.

12. A computer program product, comprising computer program code which, when executed by a processor, cause the processor to carry out the method of any one of the claims 1 to 9.

13. A computer-readable medium comprising a computer program product comprising computer program code which, when executed by a processor, cause the processor to carry out the method of any one of the claims 1 to 9.
